# EUROPÄISCHE PATENTSCHRIFT

(11) **EP 0 788 726 B1**
(45) Veröffentlichungstag und Bekanntmachung des Hinweises auf die Patenterteilung: **15.07.1998**
(21) Anmeldenummer: 95935808.6
(22) Anmeldetag: 25.10.1995
(51) Int. Cl.: H05K 1/14, H05K 7/02

(54) **STROMVERSORGUNGSMODUL ZUR BESTÜCKUNG EINER BAUGRUPPENLEITERPLATTE**
CURRENT SUPPLY MODULE FOR MOUNTING ON A COMPONENT-CARRYING PRINTED CIRCUIT BOARD
MODULE D'ALIMENTATION EN COURANT A MONTER SUR UNE PLAQUETTE DE CIRCUITS IMPRIMES A COMPOSANTS ELECTRONIQUES

(30) Priorität: 27.10.1994 DE 9417299 U
(43) Veröffentlichungstag der Anmeldung: 13.08.1997
(73) Patentinhaber: SIEMENS AKTIENGESELLSCHAFT, 80333 München (DE)
(72) Erfinder: BRAKUS, Bogdan, D-82131 Stockdorf (DE)
(86) Internationale Anmeldenummer: DE9501485
(87) Internationale Veröffentlichungsnummer: WO9613966

(56) Entgegenhaltungen:
- DE-A- 3 709 222
- DE-A- 4 116 826
- US-A- 3 201 655
- PATENT ABSTRACTS OF JAPAN vol. 18 no. 88 (E-1507) ,14.Februar 1994 & JP,A,05 292744 (HIRAHARA MINORU) 5.November 1993,

## Beschreibung

Die Erfindung betrifft ein Stromversorgungsmodul zur Bestükkung einer Baugruppenleiterplatte, bei dem die einzelnen Bauelemente auf einer Modulleiterplatte angeordnet sind.

In der modernen Systemtechnik werden für die Versorgung elektronischer Schaltungen zunehmend DC/DC-Umrichter direkt auf den Systembaugruppen untergebracht. Dabei besteht seitens der Anwender der Wunsch nach möglichst kleinen und flachen Modulen.

Der typische Wirkungsgrad eines DC/DC-Umrichters beträgt ca. 80 Prozent. Etwa 20 Prozent der umgesetzten Leistung muß vom Umrichter selbst entwärmt werden. Die Verlustwärme entsteht zum größten Teil im Kristall der Leistungshalbleiter. Ein Umrichter kann nur dann in seiner Größe optimiert werden, wenn es gelingt, seine Verlustwärme von den ausgesprochenen "Hot Spots" ohne größere Temperaturdifferenzen an die Oberfläche zu transportieren und zu verteilen. Im Idealfall ist die Oberfläche des Umrichters unter vorgegebenen Umgebungsbedingungen exakt nach seiner Verlustleistung bemessen.

Neben der Modulgröße, Entwärmung und Temperaturverteilung treten bei der Realisierung weitere Probleme, wie z.B. Gewicht, Montageaufwand, mechanische Beanspruchungen, usw. auf.

Bei der gängigen Modultechnologie werden elektrische Bauteile auf einer oder mehreren kleinen Epoxy-Leiterplatten untergebracht. Der Wärmetransport erfolgt von den "Hot Spots" über eine Vergußmasse an die Oberfläche des Gehäuses. Neben den hohen Herstellkosten entsteht dabei ein erhebliches Zusatzgewicht. Die Folge davon ist eine starke Belastung der Befestigungsstifte während eines Transports und durch sonstige Vibrationen. Solche Module müssen zusätzlich mechanisch auf der Leiterplatte fixiert werden (durch Schrauben, Klammern usw.), was mit weiteren Kosten verbunden ist.

In einigen Fällen wird anstelle der Epoxy-Platten die Hybridtechnik angewandt. Dabei erfolgt die elektrische und mechanische Kontaktierung über einige wenige kräftige Anschlußstifte. Solche Hybride werden aus Gründen der mechanischen Stabilisierung von Substrat und Anschlußstiften in einem Gehäuse untergebracht und vergossen. Dabei entstehen die obengenannten beschriebenen Probleme. Bei einigen Ausführungen werden die steifen Anschlußstifte über spezielle Rahmenkonstruktionen stabilisiert und mit dem Gehäuse und dem Substrat fixiert.

Alle diese bekannten Techniken sind mit erheblichen Nachteilen sowie hohen Herstellungskosten verbunden. Außerdem werden solche Module nicht optimal entwärmt, da die untere Fläche, um Bauhöhe zu sparen, praktisch immer auf der Baugruppenleiterplatte aufliegt. Dadurch wird der Luftdurchsatz stark behindert, so daß die optimale Größe des Moduls nicht erreicht werden kann.

Die Aufgabe der vorliegenden Erfindung besteht darin, eine optimale Gesamtlösung für die Gestaltung derartiger Stromversorgungsmodule zu finden.

Diese Aufgabe wird erfindungsgemäß für ein Stromversorgungsmodul der eingangs genannten Art dadurch gelöst, daß die aktiven Bauteile in offener Bauweise auf einer mittels Dickschichttechnologie hergestellten, als Modulleiterplatte dienenden Keramikplatte angeordnet sind, daß an zwei gegenüberliegenden Kanten der Keramikplatte zwei Reihen von hinreichend dünnen und langen Anschlußstiften angeordnet sind, wobei der Abstand zwischen den Anschlußstiften minimal ist und die Anschlußstifte waagerecht in Verlängerung der Unterseite der Keramikplatte weggeführt sind und in ihrem Mittenbereich U-förmige Ausbiegungen aufweisen, und daß das Modul in einem Durchbruch der Baugruppenleiterplatte angeordnet ist, wobei die Unterseite der Keramikplatte mit der Unterseite der Baugruppenleiterplatte fluchtet.

Die Herstellung des erfindungsgemäßen Stromversorgungsmodul ist mit einem geringen Aufwand durchzuführen. Durch die offene Bauweise werden die Wärmeabführungsprobleme zuverlässig gelöst. Durch die zwei Reihen von hinreichend dünnen und langen Anschlußstiften wird das Stromversorgungsmodul zuverlässig und elastisch getragen. Dabei werden Krümmungen und Verformungen der Modulleiterplatte, verursacht durch Erwärmung, mechanische Verspannungen usw. leicht abgefangen. Weiterhin kann der Luftdurchsatz weitgehendst ungehindert ablaufen. Dadurch wird eine optimale Entwärmung bei einer minimalen Bauhöhe erzielt.

Die mechanische Belastung des Stromversorgungsmoduls sowie der Kontaktierung ist durch die geringe Kraftübertragung des einzelnen dünnen und langen Anschlußstifts sehr klein. Darüberhinaus ist die elektrische Kontaktierung über mehrere dünne Stifte wesentlich günstiger als über wenige Anschlüsse mit größerem Durchmesser. Diese Technik ermöglicht auch unmittelbar großflächige Stromübertragungen.

Die Leistungshalbleiter werden direkt auf die Keramikplatte aufgebracht und gebonded. Dadurch ist der Wärmeübergangswiderstand der wesentlichen Wärmequellen zum Substrat hin minimiert. Da die laterale Wärmeverteilung im Substrat sehr gut ist, dient die gesamte Fläche der Keramikplatte als Kühlkörper. Dadurch sind zusätzliche Wärmetransportmittel, wie z.B. eine Vergußmasse überflüssig.

Gleichzeitig wird die Höhe des Stromversorgungsmoduls auf der Systembaugruppe um die Dicke der Leiterplatte selbst reduziert. Dabei sind die Anschlußstifte so geformt, daß die auftretenden Tangentialkrafte abgefangen werden können.

Eine zweckmäßige Ausgestaltung der Erfindung ist dadurch gekennzeichnet, daß die modulseitigen Enden der Anschlußstifte gabelförmig ausgebildet sind und die Kanten der Keramikplatte beidseitig umfassen, und daß die Anschlußstifte zur Bestükkungsseite des Moduls hin abgebogen sind. Dadurch wird eine sichere Verbindung zwischen Anschlußstiften und Keramikplatte des Stromversorgungsmoduls erreicht.

Nachstehend wird die Erfindung anhand von in der Zeichnung dargestellten Ausführungsbeispielen näher beschrieben.

Es zeigen
- FIG 1: eine Draufsicht auf ein bekanntes Stromversorgungsmodul, welches auf einer Baugruppenleiterplatte montiert ist,
- FIG 2: eine Seitenansicht der in FIG 1 dargestellten Anordnung,
- FIG 3: eine andere Seitenansicht der in FIG 1 dargestellten Anordnung,
- FIG 4: eine Keramikplatte eines Stromversorgungsmoduls mit Anschlußstiften für eine SMD-Montage,
- FIG 5: ein Stromversorgungsmodul gemäß der vorliegenden Erfindung, welches in einem Durchbruch einer Baugruppenleiterplatte montiert ist,
- FIG 6: einen teilweisen Querschnitt durch die in FIG 5 gezeigte Anordnung.

Das auf die Leiterplatte LP einer Baugruppe zu montierende Stromversorgungsmodul SVM besteht im wesentlichen aus einer Keramikplatte KP, auf welcher die aktiven Bauteile AB montiert sind. An zwei gegenüberliegenden Rändern der Keramikplatte sind die Anschlußstifte AS-S angebracht. Die Anschlußstifte AS-S sind hinreichend dünn und lang ausgebildet und weisen jeweils einen minimalen Abstand auf. Auf diese Weise werden Krümmungen und Verformungen der Leiterplatte, verursacht durch Erwärmung oder mechanische Spannungen, leicht abgefangen. Auch kann eine günstigere elektrische Kontaktierung erfolgen, da eine großflächige Stromzuführung über mehrere Anschlüsse möglich ist.

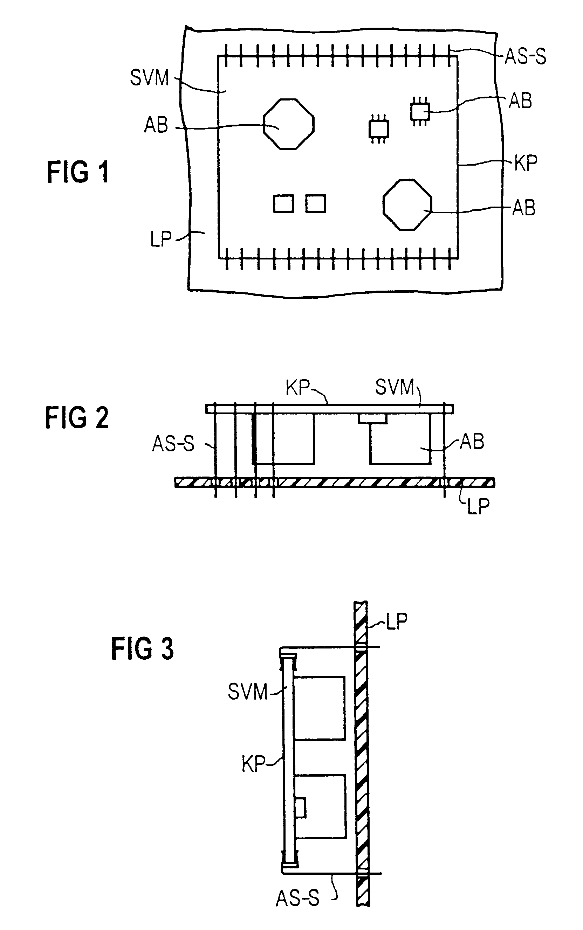

In den FIG 1 bis 3 ist eine bekannte Bestückung der Baugruppenleiterplatte LP mit einem Stromversorgungsmodul SVM (siehe z. B. JP-A-5 292 744) gezeigt, bei welchem die Bestückungsseite des Stromversorgungsmoduls SVM im montierten Zustand der Oberfläche der Leiterplatte LP zugewandt ist. Auf diese Weise wird eine minimale Bauhöhe bei gleichzeitiger guter Belüftung der aktiven Bauelemente AB erreicht.

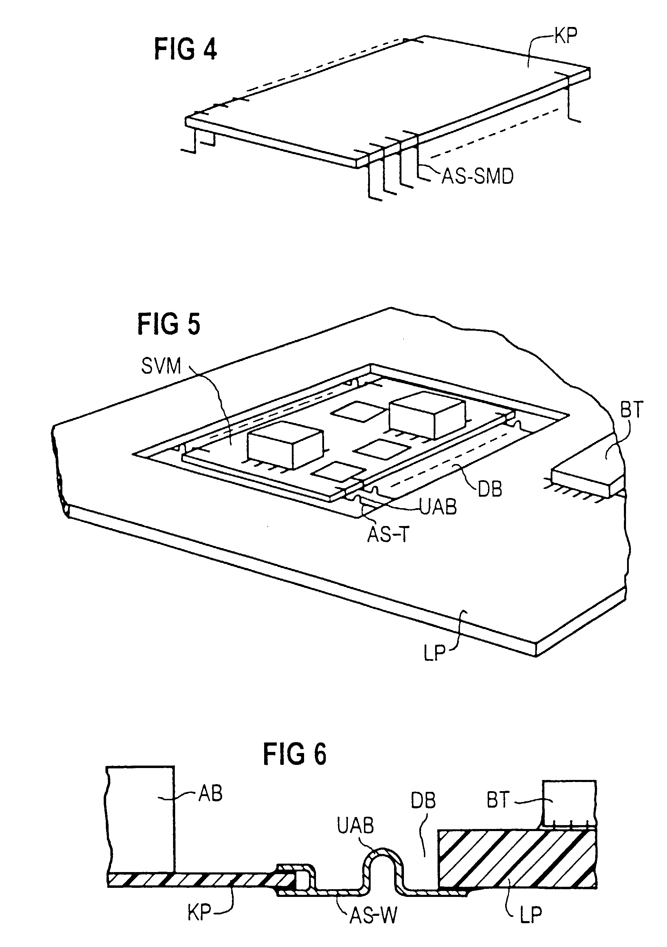

Eine weitere Verringerung der Bauhöhe ergibt sich dadurch, daß, wie in FIG 5 und in FIG 6 dargestellt ist, das erfindungsgemäße Stromversorgungsmodul SVM innerhalb eines Durchbruchs DB der Leiterplatte LP angeordnet ist. Bei dieser Ausführungsform wird die Bauhöhe des Stromversorgungsmoduls im eingebauten Zustand um die Dicke der Leiterplatte LP verringert. Bei dieser Ausführungsform sind die Anschlußstifte AS-T und AS-W waagerecht in Verlängerung der Unterseite der Keramikplatte KP geführt und weisen U-förmige Ausbiegungen auf. Durch die U-förmigen Ausbiegungen UAB wird erreicht, daß die auftretenden Tangentialkräfte abgefangen werden können.

Um eine sichere Verbindung der Anschlußstifte AS-T und AS-W zu erreichen, sind die modulseitigen Enden dieser Anschlußstifte gabelförmig ausgebildet, um die Kanten der Keramikplatte KP beidseitig zu umfassen.

In FIG 4 ist eine Keramikplatte KP eines Stromversorgungsmoduls dargestellt, bei dem die Anschlußstifte AS-SMD für eine SMD-Montage geeignet sind.

## Patentansprüche

1. Stromversorgungsmodul zur Bestückung einer Baugruppenleiterplatte, bei dem die einzelnen Bauelemente auf einer Modulleiterplatte angeordnet sind,
**dadurch gekennzeichnet,**
daß die aktiven Bauteile (AB) in offener Bauweise auf einer mittels Dickschichttechnologie hergestellten, als Modulleiterplatte dienenden Keramikplatte (KP) angeordnet sind, daß an zwei gegenüberliegenden Kanten der Keramikplatte zwei Reihen von hinreichend dünnen und langen Anschlußstiften (AS) angeordnet sind, wobei der Abstand zwischen den Anschlußstiften (AS) minimal ist und die Anschlußstifte (AS-T,AS-W) waagerecht in Verlängerung der Unterseite der Keramikplatte (KP) weggeführt sind und in ihrem Mittenbereich U-förmige Ausbiegungen (UAB) aufweisen, und daß das Modul (SVM) in einem Durchbruch (DB) der Baugruppenleiterplatte angeordnet ist, wobei die Unterseite der Keramikplatte (KP) mit der Unterseite der Baugruppenleiterplatte (LP) fluchtet.

2. Stromversorgungsmodul nach Anspruch 1,
**dadurch gekennzeichnet**,
daß die modulseitigen Enden der Anschlußstifte (AS) gabelförmig ausgebildet sind und die Kanten der Keramikplatte (KP) beidseitig umfassen, und daß die Anschlußstifte (AS-W) zur Bestückungsseite des Moduls (SVM) hin abgebogen sind.

## Claims

1. Current supply module for mounting on a component-carrying printed-circuit board, in which the individual components are arranged on a module printed-circuit board, characterized in that the active components (AB) are arranged in an open construction on a ceramic board (KP) produced by means of thick-film technology and serving as a module printed-circuit board, in that two rows of sufficiently thin and long terminal pins (AS) are arranged on two opposite edges of the ceramic board, the distance between the terminal pins (AS) being minimal and the terminal pins (AS-T, AS-W) being extended away horizontally as a continuation of the underside of the ceramic board (KP) and having U-shaped bends (UAB) in their central region, and in that the module (SVM) is arranged in an opening (DB) in the component-carrying printed-circuit board, the underside of the ceramic board (KP) being flush with the underside of the component-carrying printed-circuit board (LP).

2. Current supply module according to Claim 1, characterized in that the ends of the terminal pins (AS) on the module side are formed in a fork-shaped manner and grip around the edges of the ceramic board (KP) from both sides, and in that the terminal pins (AS-W) are bent away towards the mounting side of the module (SVM).

## Revendications

1. Module d'alimentation en courant à insérer sur une plaquette à circuits imprimés modulaire, dans lequel les composants individuels sont montés sur une plaquette à circuits imprimés modulaire, caractérisé en ce que les composants AB actifs sont montés en mode de construction ouvert sur une plaquette (KP) en céramique produite au moyen d'une technologie des couches épaisses servant de la plaquette à circuits imprimés modulaire, en ce que deux rangées de broches (AS) de raccordement suffisamment minces et longues sont montées sur deux côtés opposés de la plaquette en céramique, la distance entre les broches AS de raccordement étant minimum et les broches (AS-T, AS-W) de raccordement étant sorties horizontalement dans le prolongement de la face inférieure de la plaquette (KP) en céramique et comportant dans leur zone médiane des incurvations (UAB) en forme de U, et en ce que le module (SVM) est monté dans un passage (DB) de la plaquette à circuits imprimés modulaire, la face inférieure de la plaquette (KP) en céramique, étant à affleurement avec la face inférieure de la plaquette (LP) à circuit imprimé modulaire.

2. Module d'alimentation en courant suivant la revendication 1, caractérisé en ce que les extrémités des broches (AS) de raccordement situées du côté du module sont réalisées en forme de fourche et entourent de part et d'autre les côtés de la plaquette (KP) en céramique et en ce que les broches (AS-W) de raccordement sont recourbées en direction du côté d'insertion du module (SVM).
